**Europäisches Patentamt**

**European Patent Office**

**Office européen des brevets**

(19)

(11) Veröffentlichungsnummer: **0 180 034**
**B1**

(12)

# EUROPÄISCHE PATENTSCHRIFT

(45) Veröffentlichungstag der Patentschrifft:
21.03.90

(51) Int. Cl. ⁵: **G 01 R 33/06**

(21) Anmeldenummer: **85112087.3**

(22) Anmeldetag: **24.09.85**

(54) **Vorrichtung mit zwei Hallgeneratoren zur Messung der Gradienten magnetischer Felder.**

(30) Priorität: **27.09.84 DE 3435455**

(43) Veröffentlichungstag der Anmeldung:
**07.05.86 Patentblatt 86/19**

(45) Bekanntmachung des Hinweises auf die Patenterteilung:
**21.03.90 Patentblatt 90/12**

(54) Bennante Vertragsstaaten:
**DE FR GB IT**

(56) Entgegenhaltungen:
**DE-A-3 305 888**
**DE-B-1 098 584**
**DE-B-1 194 971**
**DE-B-1 257 273**
**US-A-3 710 236**

(73) Patentinhaber: **Nukem GmbH**
**Rodenbacher Chaussee 6 Postfach 11 00 80**
**D-6450 Hanau 11 (DE)**

(72) Erfinder: **Hüschelrath, Gerhard**
**Beethovenstrasse 6**
**D-8752 Laufach-Frohnhofen (DE)**
Erfinder: **Diehl, Herbert**
**Mühlstrasse 19**
**D-6455 Erlensee (DE)**

(74) Vertreter: **Stoffregen, Hans-Herbert, Dr. Dipl.-Phys.**
**Patentanwälte Strasse & Stoffregen Salzstrasse 11a**
**Postfach 2144**
**D-6450 Hanau/Main 1 (DE)**

EP 0 180 034 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine Vorrichtung mit zwei in Plättchenform vorliegenden Hallgeneratoren mit jeweils zwei Steuer- und zwei Hallelektroden zur Messung der Gradienten magnetischer Streufelder in der zerstörungsfreien Werkstoffprüfung, wobei die Hallgeneratoren über zwei Steuerelektroden und über zwei Hallelektroden miteinander verbunden sind, die jeweils entgegengesetzte Polaritäten der Hallspannungen aufweisen.

Es ist bekannt, jeweils zwei Hallgeneratoren, deren Hallspannungen voneinander subtrahiert werden, zur Messung der Gradienten magnetischer Streufelder bei der zerstörungsfreien Werkstoffprüfung von Werkstoffen nach dem Streuflußverfahren einzusetzen. Die beiden Hallgeneratoren sind dabei in zwei verschiedenen Ebenen parallel zueinander angeordnet und überlappen sich teilweise. Die Breitseiten der Hallgeneratoren sind in geringem Abstand von der Oberfläche des zu prüfenden ferromagnetischen Körpers ausgerichtet (US-A-3 710 236). Mit dieser bekannten Anordnung lassen sich Gefügestörungen erfassen, die sich zumindest teilweise in einer Ebene erstrecken, die senkrecht zu den Breitseiten der Hallgeneratoren und parallel zu durch die Verbindungsstellen der Hallelektroden gelegten Ebenen verläuft.

Der DE-A1-3 305 888 ist ein Gerät mit Hallsonden für die Messung von magnetischen Potentialen zu entnehmen. Dabei werden die Spannungen aller entlang einer gemeinsamen Linie angeordneten Hallsonden aufsummiert. Mit dem Gerät wird der Gradient des magnetischen Potentials gemessen.

In der gattungsbildenden DE-B-1 257 273 ist eine Vorrichtung mit zwei Hallgeneratoren dargestellt, die Plättchen enthalten, die mit ihren größeren Flächen parallel zueinander angeordnet sind. Die Hallelektroden der Plättchen sind so miteinander verbunden, daß nur die Differenz der Hallspannungen abgegriffen werden kann. Durch die Ausrichtung der Plättchen zueinander ist eine dichte Packung gleicher Vorrichtungen nicht möglich, so daß folglich eine genaue Lokalisierung von Fehlern schwer möglich ist.

Aus der DE-B-1 194 971 geht eine Meßfeldsonde mit zwei Hallgeneratoren hervor, die mit gleichgroßem Richtungseffekt derart in ein Magnetfeld angeordnet werden, daß sich der Richtungseffekt aufhebt, so daß der Betrag der Summenhallspannung von der Richtung des Magnetfelds unabhängig ist. Gemäß Fig. 3 der DE-B-1 194 971 können zwei Hallgeneratoren entlang einer Linie im Luftspalt zwischen zwei Polschuhen eines Magneten angeordnet werden. Ein Einsatz bei der zerstörungsfreien Werkstoffprüfung ist hierdurch nicht möglich.

Der Erfindung liegt die Aufgabe zugrunde, eine Vorrichtung der eingangs genannten Art so weiterzubilden, die eine möglichst dichte Anordnung mehrerer untereinander gleicher Vorrichtungen in bezug auf die Oberfläche eines Prüflings und in geringem Abstand von dieser ermöglicht.

Die Aufgabe wird erfindungsgemäß dadurch gelöst, daß die Hallgeneratoren je mit einer ihrer Breitseiten auf einem gemeinsamen ebenen Trägersubstrat im Abstand voneinander längs einer gemeinsamen Linie unter gleicher Ausrichtung in bezug auf die gemeinsame Linie jeweils nahe an den Rändern zweier einander gegenüberliegender, von Anschlüssen freier Seiten des Trägersubstrats in einem Gehäuse mit sechs Anschlüssen angeordnet sind, von denen je drei an zueinander entgegengesetzten Schmalseiten des quaderförmigen Gehäuses angebracht sind, daß die beiden miteinander verbundenen Steuerelektroden der Hallgeneratoren gemeinsam an einen Anschluß gelegt sind, daß die beiden anderen Steuerelektroden mit je einem Anschluß verbunden sind, daß die zwei miteinander verbundenen Hallelektroden der Hallgeneratoren an einen gemeinsamen Anschluß gelegt sind und daß die anderen Hallelektroden der Hallgeneratoren je mit einem Anschluß verbunden sind.

Da die Hallgeneratoren nicht mehr mit ihren Breitseiten übereinander sondern nebeneinander angeordnet sind, ist die Stärke der Vorrichtung gering. Es lassen sich daher wesentlich mehr Vorrichtungen mit ihren Breitseiten aneinanderreihen und entlang der Oberfläche des zu prüfenden Körpers anordnen. Die auf die Oberfläche des Prüfkörpers projizierte Fläche der mit den Schmalseiten übereinander angeordneten Hallgeneratoren ist kleiner als bei zwei mit den Breitseiten übereinanderangeordneten Hallgeneratoren. Dies bedeutet, daß eine feinere Zuordnung der Oberfläche zu den Hallgeneratoren möglich ist. Deshalb ist eine genauere Lokalisierung von Fehlern möglich. Der eine der beiden Hallgeneratoren kann in relativ geringem Abstand von der Oberfläche des zu prüfenden Körpers angeordnet sein. Damit wird die Ansprechempfindlichkeit erhöht. Es sind deshalb auch relativ kleine Fehler im Prüfkörper noch erfaßbar.

Die Hallelektroden der Hallgeneratoren sind bereits auf dem Trägersubstrat in Differenzschaltung miteinander verbunden. Die Art der Verbindung mit den Anschlüssen erlaubt es, sowohl die Differenz der Hallspannungen als auch die einzelnen Hallspannungen an den Anschlüssen abzugreifen. Es ist auch möglich, den Steuerelektroden über die Anschlüsse nur einen Steuerstrom zuzuführen. In diesem Fall sind die je mit einer Steuerelektrode verbundenen Anschlüsse parallel zu schalten.

Andererseits können auch zwei getrennte Steuerströme eingespeist werden, die dann auf ein gemeinsames Potential an den miteinander verbundenen Steuerelektroden bezogen sein müssen. Vorzugsweise werden im letzteren Fall die miteinander im Gehäuse verbundenen Steuerelektroden an Massepotential gelegt. Mit einem Minimum an Anschlüssen des Gehäuses lassen sich die Hallgeneratoren somit in verschiedene Schaltungsvarianten einfügen.

Zweckmäßigerweise bestehen die Hallgeneratoren aus Galliumarsenid. Derartige Hallgeneratoren erzeugen bei relativ kleinen Abmessungen hohe Hallspannungen. Das Gehäuse besteht vorzugsweise aus Kunststoff. Mit einem Kunststoffgehäuse läßt sich die Vorrichtung kostengünstig herstellen.

Es ist vorteilhaft, die Mittellinien der rechteckigen Hallgeneratoren von dem jeweils nächstliegenden von Anschlüssen freiem Rand des Gehäuses im Abstand von etwa 0,55 mm anzuordnen. Es hat sich gezeigt, daß ein solcher Abstand unter Berücksichtigung der Gegebenheiten des Trägersubstrats, der Elektroden des Hallgenerators, der Verbindungsleitungen zu den Elektroden und der Befestigung zwischen Trägersubstrat und Kunststoffgehäuse erreichbar ist. Durch diesen geringen Abstand läßt sich der jeweilige Hallgenerator mit seiner Schmalseite sehr nahe an der Oberfläche des zu prüfenden Körpers anbringen, wodurch die Meßempfindlichkeit verbessert wird.

Vorzugsweise hat das Gehäuse eine Stärke von etwa 0,8 mm. Es können daher zahlreiche, mit ihren Breitseiten aneinandergrenzende Gehäuse zu Gruppen zusammengestellt werden, wobei dem einzelnen Gehäuse auf der Oberfläche des zu prüfenden Körpers nur ein kleiner Bereich entspricht. Gefügestörungen, die von einer Meßsonde festgestellt werden, die aus den zwei in einem Gehäuse angeordneten Hallgeneratoren besteht, können daher an der Oberfläche genau lokalisiert werden.

Bei einer anderen bevorzugten Ausführungsform beträgt der Abstand zwischen den Mitten der beiden Hallgeneratoren etwa 2,5 mm. Dieser Abstand reicht im Hinblick auf die jeweils zu dritt in einer Reihe nebeneinander angeordneten Anschlüsse des Gehäuses für einen raumsparenden Aufbau der Sonde aus.

Weitere Einzelheiten, Merkmale und Vorteile der Erfindung ergeben sich aus der folgenden Beschreibung eines zeichnerisch dargestellten Ausführungsbeispiels.

Es zeigen:

Fig. 1   eine zwei Hallgeneratoren aufweisende Meßsonde von oben,

Fig. 2   die Meßsonde gemäß Fig. 1 in Seitenansicht,

Fig. 3   eine Meßsonde von oben mit Angabe der Lage der Hallgeneratoren und

Fig. 4   ein Schaltbild der aus den Hallgeneratoren, den Anschlüssen eines Gehäuses und Verbindungsleitungen bestehenden Anordnung.

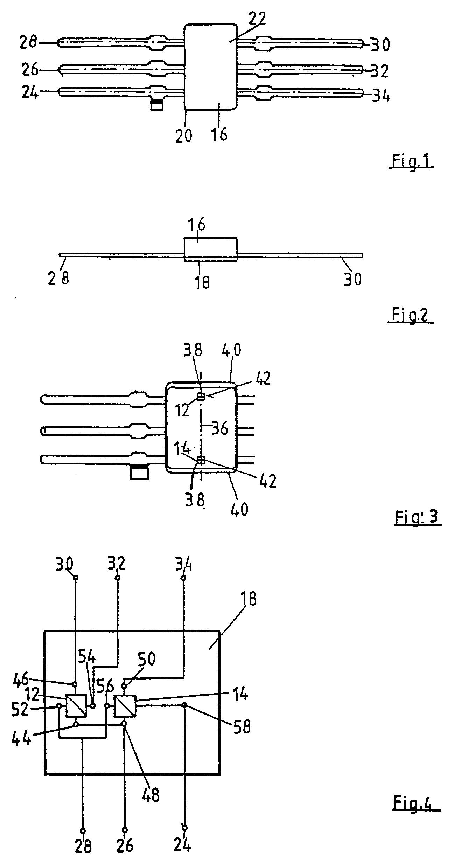

Zwei Hallgeneratoren 12, 14, die aus Galliumarsenid bestehen, sind innerhalb des in Fig. 1 dargestellten Gehäuses 16 auf einem Trägersubstrat 18 angeordnet. Das Gehäuse 16 besteht aus Kunststoff und hat eine flache Quaderform. An zwei einander entgegengesetzten Schmalseiten 20, 22 des Gehäuses 16 sind in einer Reihe nebeneinander jeweils drei Anschlüsse 24, 26, 28, 30, 32 und 34 angeordnet. Die Anschlüsse 24 bis 34 können aus geraden Metallstiften mit rechtekkigem Querschnitt bestehen. Die Breite dieser Metallstifte 24 bis 34 beträgt jeweils etwa 0,6 mm, während die Stärke etwa 0,15 - 0,2 mm ist. Die Abmessungen des Gehäuses 16 in der Länge und Breite sind etwa 3 x 4 mm.

Das Trägersubstrat 18 ist ein ebenes Plättchen. Auf der Oberfläche des Plättchens sind in einer Ebene, im Abstand voneinander die Hallgeneratoren 12, 14 längs einer gemeinsamen Linie 36 angeordnet, die in Fig. 3 strichpunktiert dargestellt ist. Die Hallgeneratoren 12, 14 sind als rechteckige Galliumarsenidplättchen ausgebildet, die in Bezug auf die Linie 36 die gleiche Winkelstellung haben. Die Galliumarsenidplättchen sind mit jeweils einem Rand 38 nahe am Rand 40 der beiden Schmalseiten des Gehäuses 16 angeordnet, die nicht mit den Anschlüssen 24 bis 34 versehen sind. Der Abstand zwischen den Rändern 40 und den jeweils durch die Mitte der Galliumarsenidplättchen parallel zu den Rändern 40 verlaufenden Mittellinien 42 beträgt etwa 0,55 mm. Zwischen den beiden Mittellinien 42 liegt ein Abstand von etwa 2,55 mm. Die Höhe der aus dem Trägersubstrat 18 und dem Kunststoffaufsatz bestehenden Anordnung beträgt 0,8 mm.

Die Hallgeneratoren 12, 14 enthalten jeweils Steuerelektroden 44, 46 und 48, 50. Die Steuerelektroden 44, 48 sind miteinander verbunden und gemeinsam an den Anschluß 8 gelegt. Die Steuerelektroden 46, 50 sind jeweils mit dem Anschluß 30 bzw. 34 verbunden. Weiterhin enthalten die Hallgeneratoren 12, 14 jeweils Hallelektroden 52, 54, 56, 58. Die beiden Hallelektroden 52, 56 sind miteinander verbunden und an den Anschluß 26 gelegt. Die Hallelektroden 54, 58 sind jeweils mit einem Anschluß 32 bzw. 24 verbunden. Die Verbindung zwischen den Hallelektroden der Hallgeneratoren 12, 14 ist so gewählt, daß die Hallspannungen einander entgegengesetzte Polaritäten aufweisen.

An den Anschlüssen 24 und 32 ist daher bereits die Differenz der Hallspannungen verfügbar. Jede einzelne Hallspannung kann aber auch für sich jeweils an den Anschlüssen 28 und 32 bzw. 28 und 24 abgegriffen werden.

Es ist möglich, den beiden Hallgeneratoren 12, 14 über den Anschluß 26 und die miteinander zu verbindenden Anschlüsse 30, 34 einen Steuerstrom zuzuführen, der sich auf die beiden Hallgeneratoren 12, 14 aufteilt. Es kann aber auch jeweils ein Steuerstrom über die Anschlüsse 30, 34 den Hallgeneratoren 12 und 14 gesondert zugeführt werden. Die Steuerströme vereinigen sich dann und fließen gemeinsam zum Anschluß 26, an den beide Steuerstromgeneratoren mit je einem Pol zu legen sind. Es ist zweckmäßig den Anschluß 26 mit Massepotential zu beaufschlagen.

Mit der in den Fig 1 bis 4 dargestellten Vorrichtung, die sich als Meßsonde insbesondere für Streuflußmessungen bei der Prüfung von ferromagnetischen Körpern mit Magnetfeldern eignet, können die Hallgeneratoren 12, 14 mit ihren Breitseiten senkrecht zu dem jeweils zu prüfenden Oberflächenelement angebracht werden. Darüberhinaus läßt sich einer der Hallgeneratoren 12 bzw. 14 in geringem Abstand von der Oberfläche des Prüflings anordnen. Hierdurch werden auch relativ geringe Streuflüsse und damit kleine Fehler im Gefüge des zu prüfenden Körpers erkannt. Durch die geringe räumliche Ausdehnung der auf die Oberfläche des Prüflings projizierten Schmalseite des jeweiligen Hallgenerators 12, 14 ist eine genauere Zuordnung von Fehlern zu den einzelnen Abschnitten des Prüflings möglich.

Es lassen sich zahlreiche Gehäuse 14 mit ihren Breitseiten nebeneinander entlang eines Streifens der Oberfläche des zu prüfenden Körpers anordnen. Der zu prüfende Körper wird dann quer zu der Reihe der Meßsonden bewegt. Eine Bewegung entlang der Reihe ist nicht erforderlich, um Fehler feststellen zu können. Die Zuordnung von Fehlern zu den jeweiligen Stellen ergibt sich aus der geometrischen Lage der einen Fehler feststellenden Hallsonde in Bezug auf den Körper.

## Patentansprüche

1. Vorrichtung mit zwei in Plättchenform vorliegenden Hallgeneratoren mit jeweils zwei Steuer- und zwei Hallelektroden zur Messung der Gradienten magnetischer Streufelder in der zerstörungsfreien Werkstoffprüfung, wobei die Hallgeneratoren über zwei Steuerelektroden (44, 48) und über zwei Hallelektroden (52 und 56) miteinander verbunden sind, die jeweils entgegengesetzte Polaritäten der Hallspannungen aufweisen, *dadurch gekennzeichnet*, daß die Hallgeneratoren (12, 14) je mit einer ihrer Breitseiten auf einem gemeinsamen ebenen Trägersubstrat (18) im Abstand voneinander längs einer gemeinsamen Linie (36) unter gleicher Ausrichtung in bezug auf die gemeinsame Linie (36) jeweils nahe an den Rändern (40) zweier einander gegenüberliegender, von Anschlüssen freier Seiten des Trägersubstrats (18) in einem Gehäuse (16) mit sechs Anschlüssen (24, 26, 28, 30, 32, 34) angeordnet sind, von denen je drei an zueinander entgegengesetzten Schmalseiten (20, 22) des quaderförmigen Gehäuses (16) angebracht sind, daß die beiden miteinander verbundenen Steuerelektroden (44, 48) der Hallgeneratoren (12, 14) gemeinsam an einen Anschluß (26) gelegt sind, daß die beiden anderen Steuerelektroden (46, 50) mit je einem Anschluß (30, 34) verbunden sind, daß die zwei miteinander verbundenen Hallelektroden (52, 56) der Hallgeneratoren (12, 14) an einen gemeinsamen Anschluß gelegt sind und daß die anderen Hallelektroden (54, 58) der Hallgeneratoren (12, 14) je mit einem Anschluß (32, 24) verbunden sind.

2. Vorrichtung nach Anspruch 1, *dadurch gekennzeichnet*, daß die Hallgeneratoren (12, 14) aus Galliumarsenid bestehen.

3. Vorrichtung nach Anspruch 1 oder 2, *dadurch gekennzeichnet*, daß die Mittellinien (42) der rechteckigen Plättchen der Hallgeneratoren (12, 14) von dem jeweils nächstliegenden, von Anschlüssen freien Rand des Gehäuses (16) im Abstand von 0,55 mm angeordnet sind.

4. Vorrichtung nach einem der vorausgehenden Ansprüche, *dadurch gekennzeichnet*, daß das Gehäuse (16) unter Einschluß des Trägersubstrats (18) eine Stärke von 0,8 mm hat.

5. Vorrichtung nach einem der vorausgehenden Ansprüche, *dadurch gekennzeichnet*, daß der Abstand zwischen den Mitten der beiden Hallgeneratoren (12, 14) etwa 2,55 mm beträgt.

## Claims

1. Apparatus having two plate-like Hall generators each with two control electrodes and two Hall electrodes for measuring the gradients of stray magnetic fields during non-destructive material testing, the Hall generators being interconnected by way of two control electrodes (44, 48) and two Hall electrodes (52 and 56), which each have opposite polarities to the Hall voltages, *characterised* in that the Hall generators (12, 14) are each disposed with one of their broad sides on a common flat carrier substrate (18) spaced apart from one another along a common line (36) with the same alignment relative to the common line (36) each close to the edges (40) of two opposing, connection-free sides of the carrier substrate (18) in a housing (16) having six connections (24, 26, 28, 30, 32, 34) which are attached in groups of three to opposing narrow sides (20, 22) of the cuboid housing (16), that the two interconnected control electrodes (44, 48) of the Hall generators (12, 14) are jointly connected to a connection (26), that the other two control electrodes (46, 50) are each connected to a connection (30, 34), that the two interconnected Hall electrodes (52, 56) of the Hall generators (12, 14) are connected to a common connection and that the other Hall electrodes (54, 58) of the Hall generators (12, 14) are each connected to a connection (32, 24).

2. Apparatus according to claim 1, *characterised* in that the Hall generators (12, 14) are made of gallium arsenide.

3. Apparatus according to claim 1 or 2, *characterised* in that the centre lines (42) of the rectangular plates of the Hall generators (12, 14) are each disposed at a distance of 0.55 mm from the closest, connection-free edge of the housing (16).

4. Apparatus according to one of the preceding claims, *characterised* in that the housing (16) including the carrier substrate (18) is 0.8 mm thick.

5. Apparatus according to one of the preceding claims, *characterised* in that the distance between the centres of the two Hall generators (12, 14) is approximately 2.55 mm.

## Revendications

1. Dispositif comportant deux générateurs de Hall se présentant sous la forme de plaquettes, pourvus chacun de deux électrodes de commande et de deux électrodes de Hall, pour mesurer les gradients de champs de dispersion magnétiques dans l'examen de matériaux exempt de perturbations, les générateurs de Hall étant reliés l'un à l'autre par l'intermédiaire de deux électrodes de commande (44, 48) et par l'intermédiaire de deux électrodes de Hall (52, 56), qui présentent chaque fois des polarités opposées des tensions de Hall, dispositif caractérisé en ce que les générateurs de Hall (12, 14) sont montés chacun par l'une de leurs faces larges sur un substrat de support (18) plan, commun, à distance l'un de l'autre le long d'une ligne commune (36) en présentant la même orientation par rapport à cette ligne commune (36), chacun très près des bords (40) de leurs côtés du substrat de support (18) situés à l'opposé l'un de l'autre et exempts de raccordements, le tout dans un boîtier (16) pourvu de six raccordements (24, 26, 28, 30, 32, 34), dont chaque fois trois de ces raccordements sont branchés sur des faces étroites (20, 22), situées à l'opposé l'une de l'autre, du boîtier (16) en forme de parallélépipède rectangle, en ce que les deux électrodes de commande (44, 48) des générateurs de Hall (12, 14) reliées l'une à l'autre sont placées conjointement sur un raccordement (26), en ce que les deux autres électrodes de commande (46, 50) sont reliées chacune à un raccordement (30, 34), en ce que les deux électrodes de Hall (52, 56) des générateurs de Hall (12, 14) reliées l'une à l'autre sont placées sur un raccordement commun (28), et en ce que les autres électrodes de Hall (54, 58) des générateurs de Hall (12, 14) sont reliées chacune à un raccordement (32, 34).

2. Dispositif selon la revendication 1, caractérisé en ce que les générateurs de Hall (12, 14) sont constitués en arséniure de gallium.

3. Dispositif selon la revendication 1 ou 2, caractérisé en ce que les lignes médianes (42) des plaquettes rectangulaires des générateurs de Hall (12, 14) se trouvent disposées à une distance de 0,55 mm du bord du boîtier (16), exempt de raccordement, qui est situé chaque fois le plus près.

4. Dispositif selon l'une des revendications précédentes, caractérisé en ce que le boîtier (16), en y incluant le substrat de support (18) a une épaisseur de 0,8 mm.

5. Dispositif selon l'une des revendications précédentes, caractérisé en ce que la distance entre les lignes médianes de deux générateurs de Hall (12, 14) est de 2,55 mm environ.

EP 0 180 034 B1

Fig.1

Fig.2

Fig. 3

Fig.4

1